# EUROPÄISCHE PATENTSCHRIFT

(11) **EP 1 507 723 B1**
(45) Veröffentlichungstag und Bekanntmachung des Hinweises auf die Patenterteilung: **15.03.2006**
(21) Anmeldenummer: 03735292.9
(22) Anmeldetag: 09.05.2003
(51) Int. Cl.: B65G 47/84, B08B 9/42

(54) **VERFAHREN UND VORRICHTUNG ZUR HANDHABUNG VON WERKSTÜCKEN**
METHOD AND DEVICE FOR HANDLING WORKPIECES
PROCEDE ET DISPOSITIF POUR LA MANIPULATION DE PIECES

(30) Priorität: 24.05.2002 DE 10223288; 27.07.2002 DE 10234374
(43) Veröffentlichungstag der Anmeldung: 23.02.2005
(73) Patentinhaber: SIG Technology Ltd., 8212 Neuhausen Rhine Falls (CH)
(72) Erfinder: LITZENBERG, Michael, 21502 Geesthacht (DE); LEWIN, Frank, 22889 Tangstedt (DE); MÜLLER, Hartwig, 22952 Lütjensee (DE); VOGEL, Klaus, 22885 Barsbüttel (DE); ARNOLD, Gregor, 55294 Bodenheim (DE); BEHLE, Stephan, 55278 Hahnheim (DE); LÜTTRINGHAUS-HENKEL, Andreas, 64289 Darmstadt (DE); BICKER, Matthias, 55126 Mainz (DE); KLEIN, Jürgen, 55127 Mainz (DE); CHOINSKI, Julian, D-22359 Hamburg (DE)
(74) Vertreter: Klickow, Hans-Henning
(86) Internationale Anmeldenummer: PCT/DE2003/001509
(87) Internationale Veröffentlichungsnummer: WO 2003/099688

(56) Entgegenhaltungen:
- WO-A-00/48818
- WO-A-99/17334
- GB-A- 986 538

## Beschreibung

Die Erfindung betrifft ein Verfahren zur Handhabung von Werkstücken, bei dem die Werkstücke von einem rotierenden Kopplungsrad transportiert werden und bei dem mindestens zwei Werkstücke von einem gemeinsamen Halteelement positioniert werden, wobei die Positionierung sowohl eine Drehbewegung relativ zu einer Rotationsachse des Kopplungsrades als auch eine Drehbewegung relativ zu einer quer zur Rotationsachse des Kopplungsrades verlaufenden Drehachse umfaßt.

Die Erfindung betrifft darüber hinaus eine Vorrichtung zur Handhabung von Werkstücken, die als ein rotierendes Kopplungsrad ausgebildet ist, das mindestens ein Halteelement zur mindestens zeitweilig gemeinsamen Positionierung von mindestens zwei werkstücken aufweist und bei der das Halteelement relativ zum Kopplungsrad drehbeweglich gelagert ist.

Derartige Vorrichtungen werden beispielsweise bei der Herstellung von blasgeformten Behältern eingesetzt, um eine Übergabe von geblasenen Behältern von einer Arbeitsstation zu einer anderen Arbeitsstation mit hoher Übergabegeschwindigkeit durchführen zu können. Beispielsweise ist ein derartiges Kopplungsrad zwischen einem rotierenden Blasrad und einer Ausgabestrecke angeordnet. Eine derartige Verwendung wird in der PCT-WO 00/48818 beschrieben.

Bei einer derartigen Behälterformung durch Blasdruckeinwirkung werden Vorformlinge aus einem thermoplastischen Material, beispielsweise Vorformlinge aus PET (Polyethylenterephtalat), innerhalb einer Blasmaschine unterschiedlichen Bearbeitungsstationen zugeführt. Typischerweise weist eine derartige Blasmaschine eine Heizeinrichtung sowie eine Blaseinrichtung auf, in deren Bereich der zuvor temperierte vorformling durch biaxiale Orientierung zu einem Behälter expandiert wird. Die Expansion erfolgt mit Hilfe von Druckluft, die in den zu expandierenden Vorformling eingeleitet wird. Der verfahrenstechnische Ablauf bei einer derartigen Expansion des Vorformlings wird in der DE-OS 43 40 291 erläutert.

Der grundsätzliche Aufbau einer Blasstation zur Behälterformung wird in der DE-OS 42 12 583 beschrieben. Möglichkeiten zur Temperierung der Vorformlinge werden in der DE-OS 23 52 926 erläutert.

Innerhalb der Vorrichtung zur Blasformung können die vorformlinge sowie die geblasenen Behälter mit Hilfe unterschiedlicher Handhabungseinrichtungen transportiert werden. Bewährt hat sich insbesondere die Verwendung von Transportdornen, auf die die Vorformlinge aufgesteckt werden. Die Vorformlinge können aber auch mit anderen Trageinrichtungen gehandhabt werden. Die Verwendung von Greifzangen zur Handhabung von Vorformlingen und die Verwendung von Spreizdornen, die zur Halterung in einen Mündungsbereich des Vorformlings einführbar sind, gehören ebenfalls zu den verfügbaren Konstruktionen.

Im Hinblick auf die verwendeten Blasstationen sind unterschiedliche Ausführungsformen bekannt. Bei Blasstationen, die auf rotierenden Transporträdern angeordnet sind, ist eine buchartige Aufklappbarkeit der Formträgrer häufig anzutreffen. Es ist aber auch möglich, relativ zueinander verschiebliche oder andersartig geführte Formträger einzusetzen.

Eine weitere Anwendung der einleitend genannten Verfahren und Vorrichtungen erfolgt beispielsweise bei Behandlungsprozessen, um Kunststoffe mit Oberflächenbeschichtungen zu versehen. Insbesondere sind auch bereits derartige Behandlungsprozesse bekannt, um innere oder äußere Oberflächen von Behältern zu beschichten, die zur Verpackung von Flüssigkeiten vorgesehen sind. Darüber hinaus sind Behandlungsprozesse zur Plasmasterilisation bekannt.

In der PCT-WO 95/22413 wird eine Plasmakammer zur Innenbeschichtung von Flaschen aus PET beschrieben. Die zu beschichtenden Flaschen werden durch einen beweglichen Boden in eine Plasmakammer hineingehoben und im Bereich einer Flaschenmündung mit einem Adapter in Verbindung gebracht. Durch den Adapter hindurch kann eine Evakuierung des Flascheninnenraumes erfolgen. Darüber hinaus wird durch den Adapter hindurch eine hohle Lanze in den Innenraum der Flaschen eingeführt, um Prozeßgas zuzuführen. Eine Zündung des Plasmas erfolgt unter Verwendung einer Mikrowelle.

Aus dieser Veröffentlichung ist es auch bereits bekannt, eine Mehrzahl von Plasmakammern auf einem rotierenden Rad anzuordnen. Hierdurch wird eine hohe Produktionsrate von Flaschen je Zeiteinheit unterstützt.

In der EP-OS 10 10 773 wird eine Zuführeinrichtung erläutert, um einen Flascheninnenraum zu evakuieren und mit Prozeßgas zu versorgen. In der PCT-WO 01/31680 wird eine Plasmakammer beschrieben, in die die Flaschen von einem beweglichen Deckel eingeführt werden, der zuvor mit einem Mündungsbereich der Flaschen verbunden wurde.

Die PCT-WO 00/58631 zeigt ebenfalls bereits die Anordnung von Plasmastationen auf einem rotierenden Rad und beschreibt für eine derartige Anordnung eine gruppenweise Zuordnung von Unterdruckpumpen und Plasmastationen, um eine günstige Evakuierung der Kammern sowie der Innenräume der Flaschen zu unterstützen. Darüber hinaus wird die Beschichtung von mehreren Behältern in einer gemeinsamen Plasmastation bzw. einer gemeinsamen Kavität erwähnt.

Eine weitere Anordnung zur Durchführung einer Innenbeschichtung von Flaschen wird in der PCT-WO 99/17334 beschrieben. Es wird hier insbesondere eine Anordnung eines Mikrowellengenerators oberhalb der Plasmakammer sowie eine Vakuum- und Betriebsmittelzuleitung durch einen Boden der Plasmakammer hindurch beschrieben.

Bei der überwiegenden Anzahl der bekannten Plasmabescnichtungsverfahren werden zur Verbesserung von Barriereeigenschaften des thermoplastischen Kunststoffmaterials durch das Plasma erzeugte Behälterschichten aus Siliziumoxiden mit der allgemeinen chemischen Formel SiOₓ verwendet. Zusätzlich können in den hierdurch erzeugten Barriereschichten auch Anteile von Kohlenstoff, Wasserstoff und Stickstoff enthalten sein. Derartige Barriereschichten verhindern ein Eindringen von Sauerstoff in die verpackten Flüssigkeiten sowie ein Austreten von Kohlendioxid bei CO₂₋haltigen Flüssigkeiten.

Für die Übergabe von Vorformlingen und Behältern werden bei unterschiedlichen Bearbeitungs- und Verarbeitungsverfahren typischerweise kurvengesteuerte Übergaberäder verwendet, bei denen zum Teil die verwendeten Tragarme relativ zu einer Tragstruktur des Kopplungsrades verschwenkbar angeordnet sind. Durch die Verschwenkbarkeit der Übergabearme kann eine Abstandsveränderung der zu übergebenden Vorformlinge oder Behälter relativ zueinander vorgegeben werden. Derartige verschwenkbare Tragarme werden beispielsweise in der DE-OS 38 47 118 beschrieben. Die hier erläuterten Tragarme sind darüber hinaus auch teleskopierbar ausgebildet. Die Tragarme gemäß der PCT-WO 00/48818 sind hingegen relativ zueinander mit festen Winkelabständen angeordnet.

Bei einer Anwendung der bekannten verfahren und Vorrichtungen im Zusammenhang mit einer Bearbeitung oder Verarbeitung einer großen Anzahl von Werkstücken je Zeiteinheit werden Bearbeitungsstationen eingesetzt, die eine gleichzeitige Bearbeitung oder Verarbeitung mehrerer Werkstücke ermöglichen. Die Zuführung und Ableitung der Werkstücke führt hier häufig zu komplexen Übergabestationen mit komplizierter Kinematik der verwendeten Bauelemente.

Aufgabe der vorliegenden Erfindung ist es, ein Verfahren der einleitend genannten Art derart zu konstruieren, daß bei der Durchführung einer Übergabe der Werkstücke eine verbesserte Steuerungsmöglichkeit zur Beeinflussung des Übergabevorganges bereitgestellt wird.

Diese Aufgabe wird erfindungsgemäß dadurch gelöst, daß eine Übergabe von Werkstücken von dem Halteelement auf mindestens eine Bezugsstation für die mindestens zwei vom Halteelement positionierte Werkstücke relativ zueinander zu unterschiedlichen Zeitpunkten durchgeführt wird.

Weitere Aufgabe der vorliegenden Erfindung ist es, eine Vorrichtung der einleitend genannten Art derart zu konstruieren, daß bei einfacher Konstruktion, einer Übergabeeinrichtung eine Übergabe einer großen Anzahl von Werkstücken je Zeiteinheit unterstützt wird.

Diese Aufgabe wird erfindungsgemäß dadurch gelöst, daß das Halteelement mindestens zwei Fixierelemente für die werkstücke aufweist, die jedes mit Ansteuerungselementen versehen sind, die die Fixierelemente relativ zueinander zeitlich versetzt ansteuert.

Durch die relativ zueinander zeitversetzte Ansteuerung der im Bereich des Halteelementes angeordneten Fixierelemente ist es möglich, statt eines ausgedehnten Übergabebereiches, der zur gleichzeitigen Übergabe mehrerer Werkstücke ausgerüstet ist, lediglich Übergabepunkte vorzusehen, an denen die Werkstücke zeitlich nacheinander den Halteelementen zugeführt bzw. aus deren Bereich entnommen werden. Die zeitversetzte Ansteuerung der Fixierelemente ermöglicht somit eine erhebliche konstruktive Vereinfachung und hiermit im Zusammenhang stehende Kosteneinsparungen sowie eine verbesserte zuverlässigkeit aufgrund einer Verminderung der konstruktiven Komplexität.

Eine exakte Reproduzierbarkeit der durchzuführenden Bewegungen kann dadurch unterstützt werden daß der Übergabevorgang kurvengesteuert durchgeführt wird.

Eine vorteilhafte Steuerung der Übergabevorgänge wird dadurch erreicht daß die Werkstücke im Bereich des Halteelementes von zangenartigen Fixierelementen positioniert werden.

Zur Durchführung von exakt reproduzierbaren Bewegungen trägt es ebenfalls bei, daß die Fixierelemente kurvengesteuert betätigt werden.

Zur Unterstützung einer günstigen Schwerkrafteinwirkung wird vorgeschlagen, daß das Kopplungsrad um eine im Wesentlichen senkrecht verlaufende Rotationsachse bewegt wird.

Eine typische Handhabung von behälterartigen Werkstücken wird dadurch unterstützt, daß das Halteelement um eine im Wesentlichen horizontal verlaufende Drehachse verschwenkt wird.

Bei der Handhabung von Werkstücken mit offenen Mündungen erweist es sich insbesondere als vorteilhaft, daß das Halteelement zyklisch jeweils um 180° hin- und herverschwenkt wird.

Eine konstruktiv einfache Realisierung wird dadurch unterstützt, daß die Schwenkbewegung des Halteelementes von einer außenseitig an einem Sockel des Kopplungsrades positionierten Mantelkurve gesteuert wird.

Zur Vorgabe einer definierten Arbeitspositionierung der Fixierelemente wird vorgeschlagen, daß Zangenarme der Fixierelemente relativ zueinander federnd verspannt werden.

Eine aktive Aufbringung von Verstellkräften nur im Bereich von vorgesehenen Übergaben kann dadurch erreicht werden, die Zangenarme federnd in eine zur Fixierung des Werkstükkes vorgesehene Klemmapositionierung verspannt werden.

Eine typische Anwendung besteht darin, daß das Kopplungsrad zur Durchführung von Übergabevorgängen in einer Umgebung mindestens einer Plasmastation verwendet wird.

Insbesondere ist daran gedacht, daß die Plasmastation von einem rotierenden Plasmarad positioniert wird.

Eine weitere Anwendung besteht darin, daß das Kopplungsrad zur Durchführung von Übergabevorgängen in einer Umgebung mindestens einer Blasstation verwendet wird.

Zur Unterstützung einer hohen Produktivität wird vorgeschlagen, daß die Plasmastation von einem rotierenden Blasrad positioniert wird.

Ein typisches Anwendungsgebiet wird dadurch definiert, daß vom Kopplungsrad flaschenartige Werkstücke positioniert werden.

Eine weitere Produktivitätserhöhung kann dadurch erreicht werden, daß das Kopplungsrad zur Durchführung von Übergabevorgängen in einer Umgebung einer Behandlungsstation für die Werkstücke verwendet wird, wobei in der Behandlungsstation mindestens zwei Werkstücke gleichzeitig behandelt werden.

Eine optimale kinematische Anpassung wird dadurch erreicht, daß das Halteelement mit einer Anzahl von Fixierelementen versehen wird, die der Anzahl der gleichzeitig im Bereich der Behandlungsstation zu behandelnden Werkstücke entspricht.

In den Zeichnungen sind Ausführungsbeispiele der Erfindung schematisch dargestellt. Es zeigen:
- Fig. 1: Eine Prinzipskizze einer Mehrzahl von Plasmakammern, die auf einem rotierenden Plasmarad angeordnet sind und bei der das Plasmarad mit Eingabe-und Ausgaberädern gekoppelt ist,
- Fig. 2: eine Anordnung ähnlich zu Fig. 1, bei der die Plasmastationen jeweils mit zwei Plasmakammern ausgestattet sind,
- Fig. 3: eine perspektivische Darstellung eines Plasmarades mit einer Vielzahl von Plasmakammern,
- Fig. 4: eine perspektivische Darstellung einer Plasmastation mit einer Kavität,
- Fig. 5: eine perspektivische Darstellung eines Plasmarades mit Plasmastationen, die jeweils zwei Kavitäten aufweisen,
- Fig. 6: Eine perspektivische Darstellung einer Blasstation zur Herstellung von Behältern aus Vorformlingen,
- Fig. 7: einen Längsschnitt durch eine Blasform, in der ein Vorformling gereckt und expandiert wird,
- Fig. 8: eine Skizze zur Veranschaulichung eines grundsätzlichen Aufbaus einer Vorrichtung zur Blasformung von Behältern,
- Fig . 9: eine modifizierte Heizstrecke mit vergrößerter Heizkapazität,
- Fig. 10: eine perspektivische Darstellung eines Kopplungsrades, bei dem vier Halteelemente mit jeweils zwei Fixierelementen verwendet sind und
- Fig. 11: eine Draufsicht gemäß Blickrichtung XI in Fig. 10.

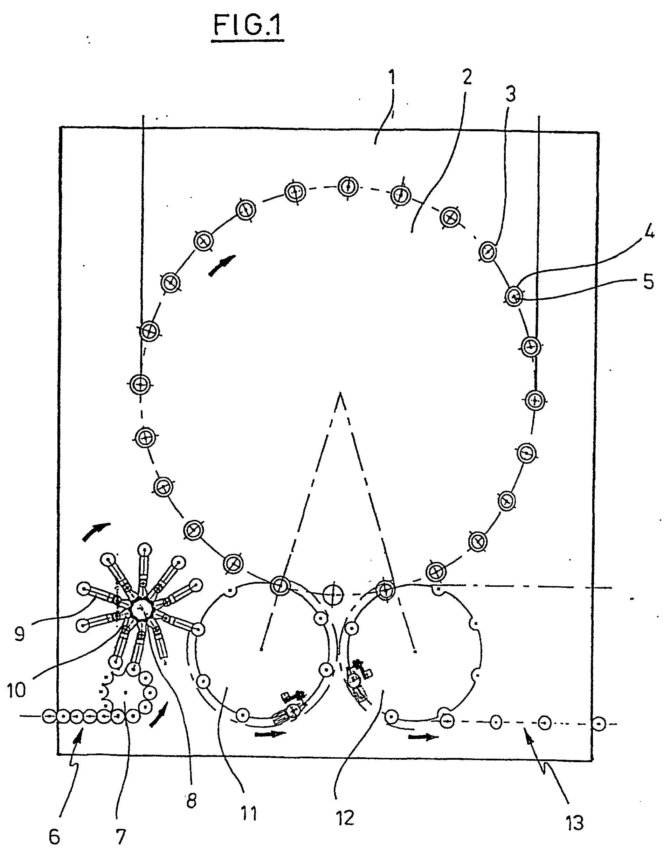

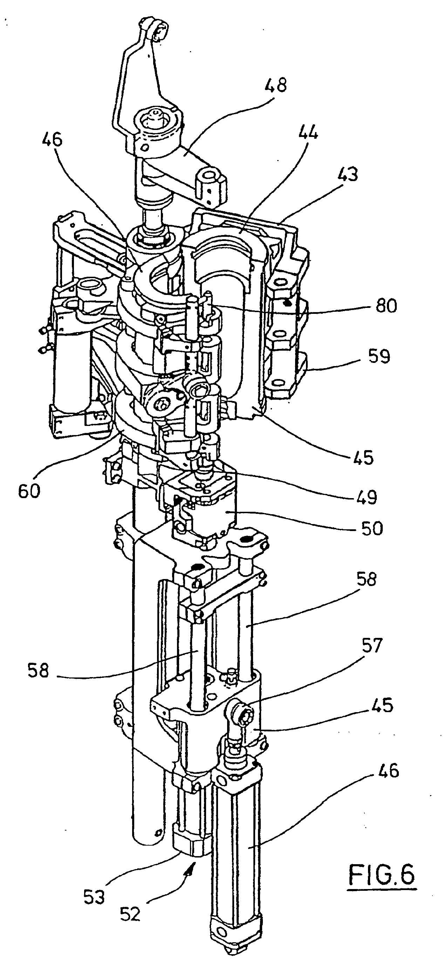

Eine Verwendung der Vorrichtung zur Handhabung von Werkstücken (5) kann beispielsweise zur Übergabe von geblasenen Behältern (42) bei einer Vorrichtung zur Plasmabehandlung oder bei einer Blasmaschine zur Behälterformung erfolgen. Der prinzipielle Aufbau einer Vorrichtung zur Plasmabehandlung ist aus Fig. 1 bis Fig. 5 ersichtlich, Vorrichtungen zur Umformung von Vorformlingen (41) in Behälter (42) sind in Fig. 6 bis Fig. 9 dargestellt.

Aus der Darstellung in Fig. 1 ist ein Plasmamodul (1) zu erkennen, das mit einem rotierenden Plasmarad (2) versehen ist. Entlang eines Umfanges des Plasmarades (2) sind eine Mehrzahl von Plasmastationen (3) angeordnet. Die Plasmastationen (3) sind mit Kavitäten (4) bzw. Plasmakammern (17) zur Aufnahme von zu behandelnden Werkstücken (5) versehen. Die zu behandelnden Werkstücke (5) werden dem Plasmamodul (1) im Bereich einer Eingabe (6) zugeführt und über ein Vereinzelungsrad (7) an ein Übergaberad (8) weitergeleitet, das mit positionierbaren Tragarmen (9) ausgestattet ist. Die Tragarme (9) sind relativ zu einem Sockel (10) des Übergaberades (8) verschwenkbar angeordnet, so daß eine Abstandsveränderung der Werkstücke (5) relativ zueinander durchgeführt werden kann. Hierdurch erfolgt eine Übergabe der Werkstücke (5) vom Übergaberad (8) an ein Eingaberad (11) mit einem relativ zum Vereinzelungsrad (7) vergrößerten Abstand der Werkstücke (5) relativ zueinander. Das Eingaberad (11) übergibt die zu behandelnden Werkstücke (5) an das Plasmarad (2). Nach einer Durchführung der Behandlung werden die behandelten Werkstücke (5) von einem Ausgaberad (12) aus dem Bereich des Plasmarades (2) entfernt und in den Bereich einer Ausgabestrecke (13) überführt.

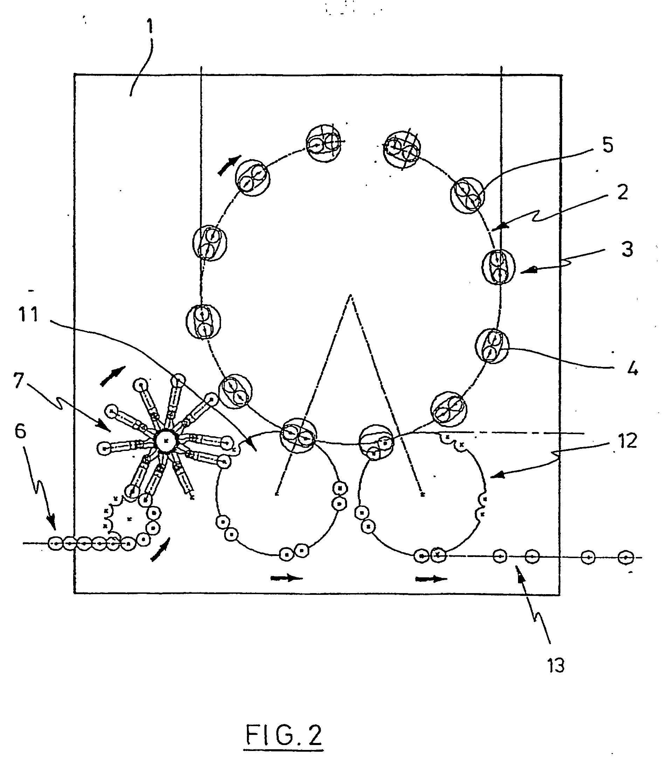

Bei der Ausführungsform gemäß Fig. 2 sind die Plasmastationen (3) jeweils mit zwei Kavitäten (4) bzw. Plasmakammern (17) ausgestattet. Hierdurch können jeweils zwei Werkstücke (5) gleichzeitig behandelt werden. Grundsätzlich ist es hierbei möglich, die Kavitäten (4) vollständig voneinander getrennt auszubilden, grundsätzlich ist es aber auch möglich, in einem gemeinsamen Kavitätenraum lediglich Teilbereiche derart gegeneinander abzugrenzen, daß eine optimale Beschichtung aller Werkstücke (5) gewährleistet ist. Insbesondere ist hierbei daran gedacht, die Teilkavitäten zumindest durch separate Mikrowelleneinkopplungen gegeneinander abzugrenzen.

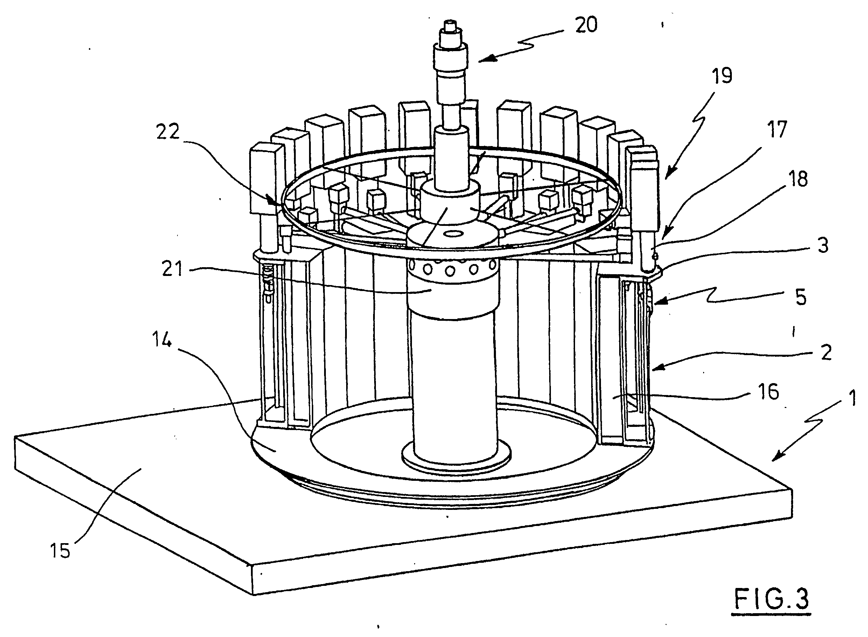

Fig. 3 zeigt eine perspektivische Darstellung eines Plasmamoduls (1) mit teilweise aufgebautem Plasmarad (2). Die Plasmastationen (3) sind auf einem Tragring (14) angeordnet, der als Teil einer Drehverbindung ausgebildet und im Bereich eines Maschinensockels (15) gelagert ist. Die Plasmastationen (3) weisen jeweils einen Stationsrahmen (16) auf, der Plasmakammern (17) haltert. Die Plasmakammern (17) weisen zylinderförmige Kammerwandungen (18) sowie Mikrowellengeneratoren (19) auf.

In einem Zentrum des Plasmarades (2) sind Drehverteiler (20, 21) angeordnet, über die die Plasmastationen (3) mit Betriebsmitteln sowie Energie versorgt werden. Zur Betriebsmittelverteilung können insbesondere Ringleitungen (22) eingesetzt werden.

Die zu behandelnden Werkstücke (5) sind unterhalb der zylinderförmigen Kammerwandungen (18) dargestellt. Unterteile der Plasmakammern (17) sind zur Vereinfachung jeweils nicht eingezeichnet.

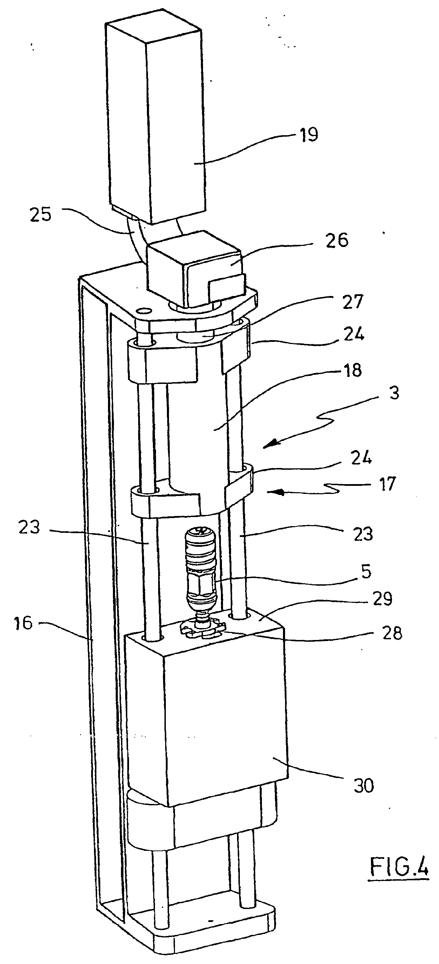

Fig. 4 zeigt eine Plasmastation (3) in perspektivischer Darstellung. Es ist zu erkennen, daß der Stationsrahmen (16) mit Führungsstangen (23) versehen ist, auf denen ein Schlitten (24) zur Halterung der zylinderförmigen Kammerwandung (18) geführt ist. Fig. 4 zeigt den Schlitten (24) mit Kammerwandung (18) in einem angehobenen Zustand, so daß das Werkstück (5) freigegeben ist.

Im oberen Bereich der Plasmastation (3) ist der Mikrowellengenerator (19) angeordnet. Der Mikrowellengenerator (19) ist über eine Umlenkung (25) und einen Adapter (26) an einen Kopplungskanal (27) angeschlossen, der in die Plasmakammer (17) einmündet. Grundsätzlich kann der Mikrowellengenerator (19) sowohl unmittelbar im Bereich eines Kammerdeckels als auch über ein Distanzelement an den Kammerdekkel angekoppelt mit einer vorgebbaren Entfernung zum Kammerdeckel und somit in einem größeren Umgebungsbereich des Kammerdeckels angeordnet werden. Der Adapter (26) hat die Funktion eines Übergangselementes und der Kopplungskanal (27) ist als ein Koaxialleiter ausgebildet. Im Bereich einer Einmündung des Kopplungskanals (27) in den Kammerdeckel ist ein Quarzglasfenster angeordnet. Die Umlenkung (25) ist als ein Hohlleiter ausgebildet.

Das Werkstück (5) wird im Bereich eines Dichtelementes (28) positioniert, das im Bereich eines Kammerbodens (29) angeordnet ist. Der Kammerboden (29) ist als Teil eines Kammersockels (30) ausgebildet. Zur Erleichterung einer Justage ist es möglich, den Kammersockel (30) im Bereich der Führungsstangen (23) zu fixieren. Eine andere Variante besteht darin, den Kammersockel (30) direkt am Stationsrahmen (16) zu befestigen. Bei einer derartigen Anordnung ist es beispielsweise auch möglich, die Führungsstangen (23) in vertikaler Richtung zweiteilig auszuführen.

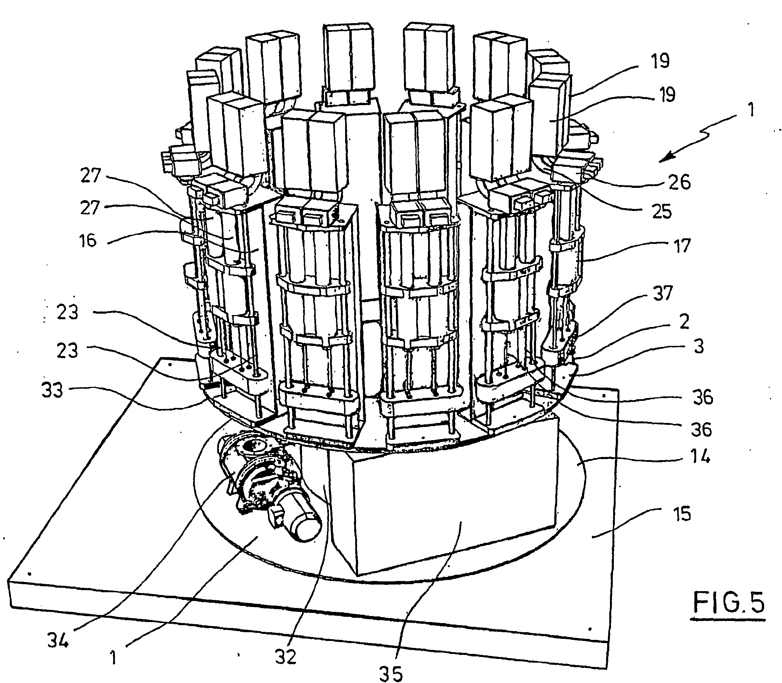

Fig. 5 zeigt ein gegenüber der Darstellung in Fig. 3 abgewandeltes Plasmamodul (1). Das Plasmarad (2) ist hier für einen umlaufenden Transport von Plasmastationen (3) ausgebildet, die mit jeweils zwei Plasmakammern (17) versehen sind. Für jede der Plasmakammern (17) weist jede der Plasmastationen (3) zwei Mikrowellengeneratoren (19), zwei Umlenkungen (25) sowie zwei Adapter (26) auf, die die Mikrowellen zur Zündung des Plasmas über Kopplungskanäle (27) in die zugeordneten Plasmakammern (17) einleiten. Der Tragring (14) des Plasmarades (2) besitzt in einem vertikalen Querschnitt ein c-förmiges Profil mit einem Basisschenkel (31), einem Distanzschenkel (32) sowie einem Abschlußschenkel (33). Der Distanzschenkel (32) verläuft im wesentlichen in einer vertikalen Richtung, der Basisschenkel und der Abschlußschenkel (33) sind im wesentlichen horizontal angeordnet. Der Basisschenkel (31) und der Abschlußschenkel (33) erstrecken sich ausgehend vom Distanzschenkel (32) in eine radial nach außen weisende Richtung.

In lotrechter Richtung oberhalb des Abschlußschenkels (32) sind die Plasmastationen (3) angeordnet. Bei der Ausführungsform gemäß Fig. 5 sind auf dem Basisschenkel (31) Fördereinrichtungen (34) für ein Betriebsmittel angeordnet. Das Betriebsmittel wird den Plasmastationen (3) zugeführt. Im dargestellten Ausführungsbeispiel ist die Fördereinrichtung (34) als eine Vakuumpumpe realisiert. Zusätzlich zu den Fördereinrichtungen (34) sind auch Verteilschränke (35) für eine elektrische Versorgung der Plasmastationen (3) auf dem Basisschenkel (31) angeordnet. Die Anordnung der Fördereinrichtungen (34) und der Verteilschränke (35) erfolgt dabei innerhalb des vom c-förmigen Profil des Tragringes (14) bereitgestellten Aufnahmeraumes.

Bei einer Rotation des Plasmarades (2) rotieren durch die erläuterte Anordnung die Fördereinrichtungen (34) und die Verteilschränke (35) gemeinsam mit den Plasmastationen (3) und es liegt auch keine Relativbewegung zwischen diesen Baugruppen vor. Entsprechende verbindungsleitungen können somit in einfacher Weise realisiert werden.

Fig. 5 zeigt die Plasmastation (3) ohne montierten Kammersockel (30) hierdurch sind Lanzen (36) zur Prozeßgaszuführung zu erkennen, die von Lanzenschlitten (37) getragen und positioniert werden. Die Lanzenschlitten sind entlang der Führungsstangen (23) positionierbar.

Eine Vorrichtung zur Blasformung eines Behälters (42) besteht gemäß Fig. 6 im wesentlichen aus einer Blasstation (43), die mit einer Blasform (44) versehen ist, in die ein vorformling (41) einsetzbar ist. Der Vorformling (41) kann ein spritzgegossenes Teil aus Polyethylenterephthalat sein. Zur Ermöglichung eines Einsetzens des Vorformlings (41) in die Blasform (44) und zur Ermöglichung eines Herausnehmens des fertigen Behälters (42) besteht die Blasform (44) aus Formhälften (45, 46) und einem Bodenteil (47), das von einer Hubvorrichtung (48) positionierbar ist. Der Vorformling (41) kann im Bereich der Blasstation (43) von einem Transportdorn (49) gehalten sein, der gemeinsam mit dem Vorformling (41) eine Mehrzahl von Behandlungsstationen innerhalb der Vorrichtung durchläuft. Es ist aber auch möglich, den Vorformling (41) beispielsweise über Zangen oder andere Handhabungsmittel direkt in die Blasform (44) einzusetzen.

Zur Ermöglichung einer Druckluftzuleitung ist unterhalb des Transportdornes (49) ein Anschlußkolben (50) angeordnet, der dem Vorformling (41) Druckluft zuführt und gleichzeitig eine Abdichtung relativ zum Transportdorn (49) vornimmt. Bei einer abgewandelten Konstruktion ist es grundsätzlich aber auch denkbar, feste Druckluftzuleitungen zu verwenden.

Eine Reckung des Vorformlings (41) erfolgt mit Hilfe einer Reckstange (51), die von einem Zylinder (52) positioniert wird. Grundsätzlich ist es aber auch denkbar, eine mechanische Positionierung der Reckstange (51) über Kurvensegmente durchzuführen, die von Abgriffrollen beaufschlagt sind. Die Verwendung von Kurvensegmenten ist insbesondere dann zweckmäßig, wenn eine Mehrzahl von Blasstationen (43) auf einem rotierenden Blasrad angeordnet sind. Eine Verwendung von Zylindern (52) ist zweckmäßig, wenn ortsfest angeordnete Blasstationen (43) vorgesehen sind.

Bei der in Fig. 6 dargestellten Ausführungsform ist das Recksystem derart ausgebildet, daß eine Tandem-Anordnung von zwei Zylindern (52) bereitgestellt ist. Von einem Primärzylinder (53) wird die Reckstange (51) zunächst vor Beginn des eigentlichen Reckvorganges bis in den Bereich eines Bodens (54) des Vorformlings (41) gefahren. Während des eigentlichen Reckvorganges wird der Primärzylinder (53) mit ausgefahrener Reckstange gemeinsam mit einem den Primärzylinder (53) tragenden Schlitten (55) von einem Sekundärzylinder (56) oder über eine Kurvensteuerung positioniert. Insbesondere ist daran gedacht, den Sekundärzylinder (56) derart kurvengesteuert einzusetzen, daß von einer Führungsrolle (57), die während der Durchführung des Reckvorganges an einer Kurvenbahn entlang gleitet, eine aktuelle Reckposition vorgegeben wird. Die Führungsrolle (57) wird vom Sekundärzylinder (56) gegen die Führungsbahn gedrückt. Der Schlitten (55) gleitet entlang von zwei Führungselementen (58).

Nach einem Schließen der im Bereich von Trägern (59, 60) angeordneten Formhälften (45, 46) erfolgt eine Verriegelung der Träger (59, 60) relativ zueinander mit Hilfe einer Verriegelungseinrichtung (80).

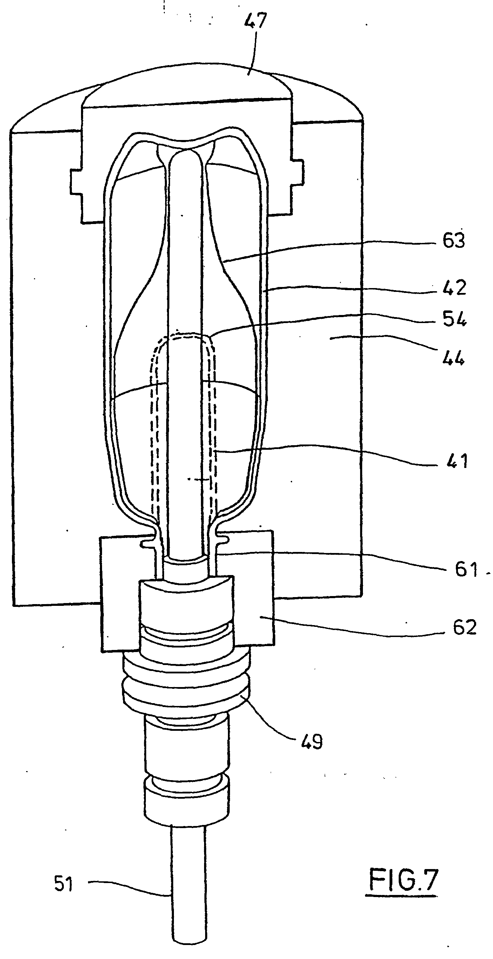

Zur Anpassung an unterschiedliche Formen eines Mündungsabschnittes (61) des Vorformlings (41) ist gemäß Fig. 2 die Verwendung separater Gewindeeinsätze (62) im Bereich der Blasform (44) vorgesehen. Fig. 7 zeigt zusätzlich zum geblasenen Behälter (42) auch gestrichelt eingezeichnet den Vorformling (41) und schematisch eine sich entwickelnde Behälterblase (63).

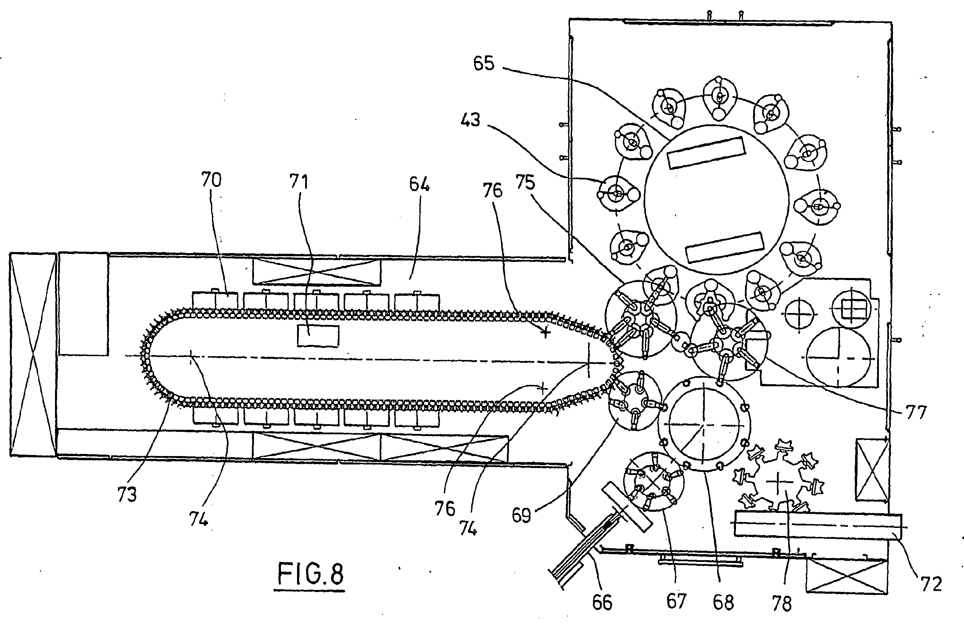

Fig. 8 zeigt den grundsätzlichen Aufbau einer Blasmaschine, die mit einer Heizstrecke (64) sowie einem rotierenden Blasrad (65) versehen ist. Ausgehend von einer Vorformlingseingabe (66) werden die Vorformlinge (41) von Übergaberädern (67, 68, 69) in den Bereich der Heizstrecke (64) transportiert. Entlang der Heizstrecke (64) sind Heizstrahler (70) sowie Gebläse (71) angeordnet, um die Vorformlinge (41) zu temperieren. Nach einer ausreichenden Temperierung der Vorformlinge (41) werden diese an das Blasrad (65) übergeben, in dessen Bereich die Blasstationen (43) angeordnet sind. Die fertig geblasenen Behälter (42) werden von weiteren Übergaberädern einer Ausgabestrecke (72) zugeführt.

Um einen Vorformling (41) derart in einen Behälter (42) umformen zu können, daß der Behälter (42) Materialeigenschaften aufweist, die eine lange verwendungsfähigkeit von innerhalb des Behälters (42) abgefüllten Lebensmitteln, insbesondere von Getränken, gewährleisten, müssen spezielle Verfahrensschritte bei der Beheizung und Orientierung der Vorformlinge (41) eingehalten werden. Darüber hinaus können vorteilhafte Wirkungen durch Einhaltung spezieller Dimensionierungsvorschriften erzielt werden.

Als thermoplastisches Material können unterschiedliche Kunststoffe verwendet werden. Einsatzfähig sind beispielsweise PET, PEN oder PP.

Die Expansion des Vorformlings (41) während des Orientierungsvorganges erfolgt durch Druckluftzuführung. Die Druckluftzuführung ist in eine Vorblasphase, in der Gas, zum Beispiel Preßluft, mit einem niedrigen Druckniveau zugeführt wird und in eine sich anschließende Hauptblasphase unterteilt, in der Gas mit einem höheren Druckniveau zugeführt wird. Während der Vorblasphase wird typischerweise Druckluft mit einem Druck im Intervall von 10 bar bis 25 bar verwendet und während der Hauptblasphase wird Druckluft mit einem Druck im Intervall von 25 bar bis 40 bar zugeführt.

Aus Fig. 8 ist ebenfalls erkennbar, daß bei der dargestellten Ausführungsform die Heizstrecke (64) aus einer Vielzahl umlaufender Transportelemente (73) ausgebildet ist, die kettenartig aneinandergereiht und entlang von Umlenkrädern (74) geführt sind. Insbesondere ist daran gedacht, durch die kettenartige Anordnung eine im wesentlichen rechteckförmige Grundkontur aufzuspannen. Bei der dargestellten Ausführungsform werden im Bereich der dem Übergaberad (69) und einem Eingaberad (75) zugewandten Ausdehnung der Heizstrecke (64) ein einzelnes relativ groß dimensioniertes Umlenkrad (74) und im Bereich von benachbarten Umlenkungen zwei vergleichsweise kleiner dimensionierte Umlenkräder (76) verwendet. Grundsätzlich sind aber auch beliebige andere Führungen denkbar.

Zur Ermöglichung einer möglichst dichten Anordnung des Übergaberades (69) und des Eingaberades (75) relativ zueinander erweist sich die dargestellte Anordnung als besonders zweckmäßig, da im Bereich der entsprechenden Ausdehnung der Heizstrecke (64) drei Umlenkräder (74, 76) positioniert sind, und zwar jeweils die kleineren Umlenkräder (76) im Bereich der Überleitung zu den linearen Verläufen der Heizstrecke (64) und das größere Umlenkrad (74) im unmittelbaren Übergabebereich zum Übergaberad (69) und zum Eingaberad (75). Alternativ zur Verwendung von kettenartigen Transportelementen (73) ist es beispielsweise auch möglich, ein rotierendes Heizrad zu verwenden.

Nach einem fertigen Blasen der Behälter (42) werden diese von einem Entnahmerad (77) aus dem Bereich der Blasstationen (43) herausgeführt und über das Übergaberad (68) und ein Ausgaberad (78) zur Ausgabestrecke (72) transportiert.

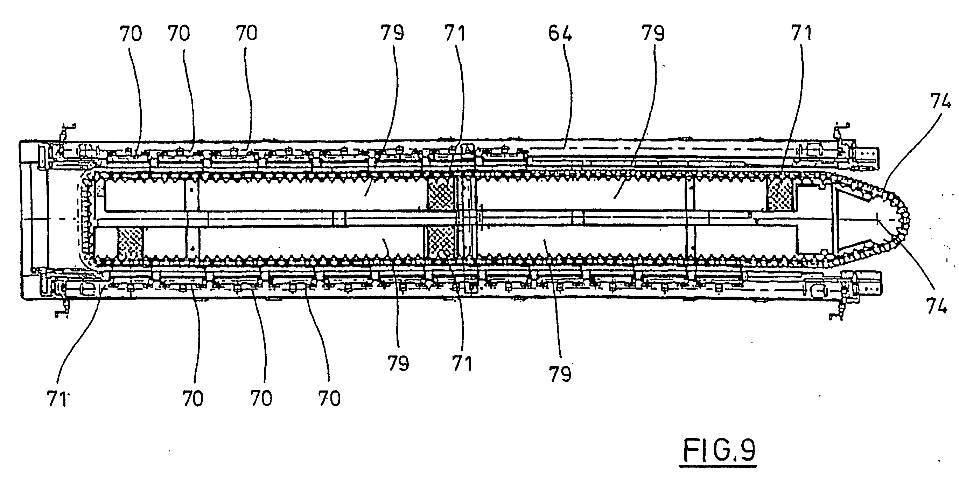

In der in Fig. 9 dargestellten modifizierten Heizstrecke (64) können durch die größere Anzahl von Heizstrahlern (70) eine größere Menge von Vorformlingen (41) je Zeiteinheit temperiert werden. Die Gebläse (71) leiten hier Kühlluft in den Bereich von Kühlluftkanälen (79) ein, die den zugeordneten Heizstrahlern (70) jeweils gegenüberliegen und über Ausströmöffnungen die Kühlluft abgeben. Durch die Anordnung der Ausströmrichtungen wird eine Strömungsrichtung für die Kühlluft im wesentlichen quer zu einer Transportrichtung der Vorformlinge (41) realisiert. Die Kühlluftkanäle (79) können im Bereich von den Heizstrahlern (70) gegenüberliegenden Oberflächen Reflektoren für die Heizstrahlung bereitstellen, ebenfalls ist es möglich, über die abgegebene Kühlluft auch eine Kühlung der Heizstrahler (70) zu realisieren.

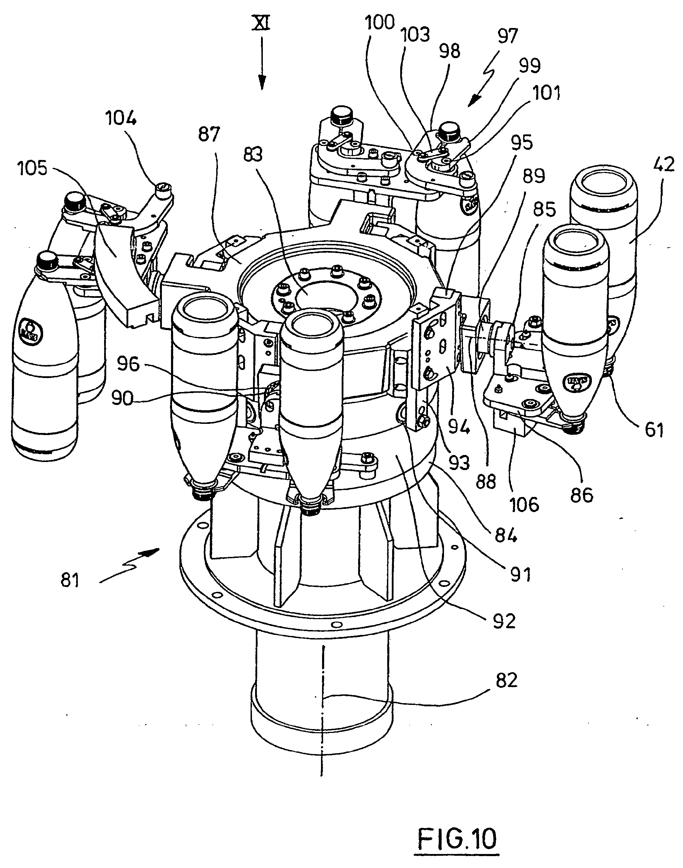

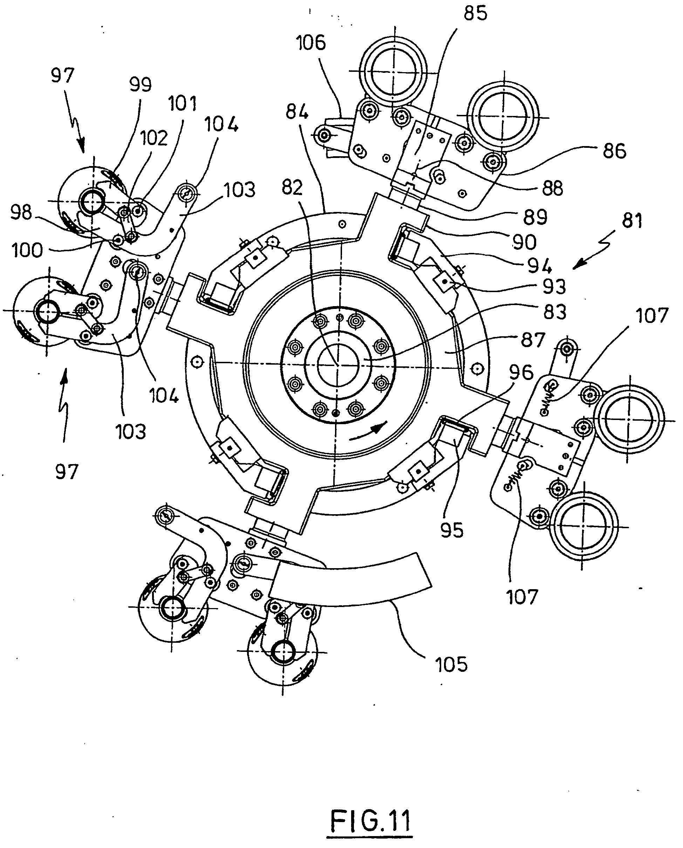

Sowohl die in Fig. 1 bis Fig. 5 dargestellten Vorrichtungen zur Plasmabehandlung von Werkstücken (5) als auch die in Fig. 6 bis Fig. 9 dargestellten Vorrichtungen zur Blasformung von Behältern (42) können mit einem oder mehreren Kopplungsrädern (81) gemäß Fig. 10 und Fig. 11 ausgestattet werden. Die Verwendung derartiger Kopplungsräder (81) ist insbesondere dann zweckmäßig, wenn Plasmastationen (3) oder Blasstationen (43) mit jeweils mehr als einer Kavität (4) verwendet werden. Die Kopplungsräder (81) werden typischerweise dazu verwendet, Werkstücke (5) in vertikaler Richtung zu drehen. Bei einer Handhabung von Behältern (42) ist insbesondere daran gedacht, eine Drehung der Werkstücke (5) bzw. der Behälter (42) in vertikaler . Richtung um eine horizontal verlaufende Drehachse durchzuführen. Typischerweise erfolgt die Drehung um 180° derart, daß eine zunächst nach oben orientierte Mündung nach unten orientiert wird bzw. eine zunächst in lotrechter Richtung nach unten weisende Mündung nach der Drehung in lotrechter Richtung nach oben weist.

Fig. 10 zeigt das relativ zu einer Mittellinie (82) rotationsfähig gelagerte Kopplungsrad (81) für Werkstücke (5) oder geblasene Behälter (42). Die rotationsfähige Lagerung kann derart realisiert sein, daß das Kopplungsrad (81) über Lager und eine Welle (83) in einem Sockel (84) geführt ist.

Außenseitig am Kopplungsrad (81) sind Tragarme (85) angeordnet, die mit Halteelementen (86) für die Behälter. (42) versehen sind. Beim dargestellten Ausführungsbeispiel beaufschlagen die Haltelemente (86) die als Behälter (42) ausgebildeten Werkstücke (5) im Bereich des Mündungsabschnittes (61) oberhalb eines Stützringes.

Die Tragarme (85) sind relativ zu einem Grundelement (87) des Kopplungsrades (81) beweglich geführt. Die Tragarme (85) sind dabei jeweils um eine Drehachse (88) herum verschwenkbar angeordnet. Die Drehachse (88) verläuft im Bereich einer Welle (89), die von Lagern (90) im Grundelement (87) geführt ist und sich im wesentlichen in horizontaler Richtung erstreckt. Die Tragarme (85) sind mit einer Kurvenrolle (91) gekoppelt, um Schwenkbewegungen um die Drehachse (88) herum vorzugeben.

Die Kurvenrollen (91) greifen in eine Kurvenbahn (92) ein, die als Mantelkurve außenseitig am Sockel (84) angeordnet ist. Beim dargestellten Ausführungsbeispiel bewegen die Kurvenrollen (91) jeweils ein Stellelement (93) in einer vertikalen Richtung. Das Stellelement (93) ist mit einem Kopplungselement (94) verbunden, das über eine zahnstangenartige Verzahnung (95) in ein Zahnrad (96) eingreift, das starr auf der Welle (89) aufsitzt. Eine Hubbewegung des Kopplungselementes (94) wird hierdurch in eine Rotationsbewegung der Welle (83) transformiert. Insbesondere ist daran gedacht, die Verzahnung derart zu wählen, daß ein maximal durchführbarer Hub der Kurvenrolle (91) in eine Drehung der Welle (89) um ein 180° transformiert wird. Die Auf- und Abbewegung der Kurvenrolle (91) wird hierdurch in eine Schwenkbewegung der Welle (89) um 180° sowie in eine entsprechende Rückbewegung umgesetzt.

Beim Ausführungsbeispiel gemäß Fig. 10 ist das Halteelement (86) mit zwei zangenartigen Fixierelementen (97) versehen, die jeweils einen Behälter (42) im Bereich des Mündungsabschnittes (61) haltern. Jedes der Fixierelemente (97) ist mit Zangenarmen (98, 99) ausgestattet, die um Schwenklager (100, 101) herum drehbeweglich angeordnet sind. Die Zangenarme (98, 99) sind von einem Kopplungshebel (102) miteinander verbunden. Der Zangenarm (98) weist einen Stellhebel (103) auf, der eine Kurvenrolle (104) trägt. Zur Positionierung der Kurvenrollen (104) sind Kurvensegmente (105, 106) verwendet. Der Stellhebel (103) verursacht durch das Zusammenarbeiten mit dem Kopplungshebel (102) vorzugsweise eine symmetrische Bewegung der beiden Zangenarme (98, 99).

Beide jeweils einem Halteelement (86) zugeordneten Kurvenrollen (104) durchlaufen die Kurvensegmente (105, 106) zeitlich nacheinander. Dies führt dazu, daß die Fixierelemente (97) zeitlich aufeinander folgend betätigt werden. Für eine Übergabe von Werkstücken (5) bzw. Behältern (42) an die Halteelemente (86) kann somit eine einzige Übergabeposition realisiert werden, in deren Bereich die Übergaben zeitlich nacheinander durchgeführt werden, obwohl die Werkstücke (5) von einem gemeinsamen Halteelement (86) weitertransportiert werden. Durch die Kombination der Kurvenrollen (104) und der Kurvensegmente (105, 106) können somit trotz des gruppenweisen Transportes der Werkstücke (5) einfache Belade- und Entladevorgänge durchgeführt werden, wie dies bei Kopplungsrädern (81) mit Tragarmen (85) möglich ist, die jeweils nur ein Halteelement (86) zur Beaufschlagung eines einzelnen Werkstückes (5) aufweisen.

Fig. 11 veranschaulicht in einer Draufsicht nochmals die Anordnung der Fixierelemente (97) sowie die jeweilige Positionierung der Fixierelemente (97). Es ist insbesondere zu erkennen, daß die Zangenarme (98, 99) von Federn (107) relativ zueinander verspannt sind. Dies führt dazu, daß ohne externe Einwirkung die Fixierelemente (97) die jeweilige Fixierpositionierung einnehmen. Lediglich bei einem Eingreifen der Kurvenrollen (104) in eines der Kurvensegmente (105, 106) werden die Fixierelemente (97) gesteuert geöffnet, um einen Übergabevorgang durchzuführen. Die Steuerung der Fixierelemente (97) auch bei einem Einsetzen der Werkstücke (5) weist den Vorteil auf, daß ein Gleitkontakt zwischen den Werkstücken (5) und den Fixierelementen (97) vermieden wird. Hierdurch wird einem Entstehen von Abrieb an den Werkstücken (5) entgegengewirkt.

Fig. 11 veranschaulicht ebenfalls, daß die Kurvenrollen (104) in einem Ruhezustand hintereinander auf einem zur Mittellinie (82) konzentrisch angeordneten Kreis bewegt werden. Dies ermöglicht die zeitlich aufeinander folgende versetzte Positionierung unter Verwendung gemeinsamer Kurvensegmente (105, 106).

Fig. 10 und Fig. 11 zeigen im Bereich jedes Halteelementes (86) Werkstücke (5) bzw. Behälter (42). Bei einem tatsächlichen Betrieb sind im Bereich des Halteelementes (86) zwischen der Ausgabeposition im Bereich des einen der Kurvensegmente (105, 106) und der Ausgabeposition im Bereich des anderen der Kurvensegmente (105, 106) aber keine derartigen Werkstücke (5) angeordnet. Die vorliegende Darstellung erleichtert aber das Verständnis des Prinzips der Bewegungsabläufe.

Ein typischer Behandlungsvorgang wird im folgenden am Beispiel eines Beschichtungsvorganges erläutert. Das Werkstück (5) wird in einem hochgeschobenen Zustand der hülsenartigen Kammerwandung (18) in die Plasmastation (3) eingesetzt. Nach einem Abschluß des Einsetzvorganges wird die Kammerwandung (18) in ihre abgedichtete Positionierung abgesenkt und zunächst gleichzeitig eine Evakuierung sowohl der Kavität (4) als auch eines Innenraumes des Werkstückes (5) durchgeführt.

Nach einer ausreichenden Evakuierung des Innenraumes der Kavität (4) wird die Lanze (36) in den Innenraum des Werkstückes (5) eingefahren und durch eine Verschiebung des Dichtelementes (28) eine Abschottung des Innenraumes des Werkstückes (5) gegenüber dem Innenraum der Kavität (4) durchgeführt. Ebenfalls ist es möglich, die Lanze (36) bereits synchron zur beginnenden Evakuierung des Innenraumes der Kavität in das Werkstück (5) hinein zu verfahren. Der Druck im Innenraum des Werkstückes (5) wird anschließend noch weiter abgesenkt. Darüber hinaus ist auch daran gedacht, die Positionierbewegung der Lanze (36) wenigstens teilweise bereits parallel zur Positionierung der Kammerwandung (18) durchzuführen. Nach Erreichen eines ausreichend tiefen Unterdruckes wird Prozeßgas in den Innenraum des Werkstückes (5) eingeleitet und mit Hilfe des Mikrowellengenerators (19) das Plasma gezündet.

Insbesondere ist daran gedacht, mit Hilfe des Plasmas sowohl einen Haftvermittler als auch die eigentliche Barriereschicht aus Siliziumoxiden auf den inneren Oberflächen der Werkstücke (5) abzuscheiden.

Die Aufbringung des Haftvermittlers kann beispielsweise in einem zweistufigen Verfahren als erste Stufe vor der Aufbringung der Barriereschicht in der zweiten Stufe erfolgen, es ist aber auch denkbar, in einem kontinuierlichen Verfahren wenigstens einen dem Werkstück (5) zugewandten Teil der Barriereschicht als Gradientenschicht auch bereits zeitgleich zum Aufbringen mindestens eines Teiles des Haftvermittlers zu erzeugen. Eine derartige Gradientenschicht kann in einfacher Weise während der Dauer eines bereits gezündeten Plasmas durch Veränderung der Zusammensetzung des Prozeßgases erzeugt werden. Eine derartige Änderung der Zusammensetzung des Prozeßgases kann abrupt durch Änderung von ventilsteuerungen oder kontinuierlich durch Veränderung des Mischungsverhältnisses von Bestandteilen des Prozeßgases erreicht werden.

Ein typischer Aufbau einer Gradientenschicht erfolgt derart, daß in einem dem Werkstück (5) zugewandten Teil der Gradientenschicht ein zumindest überwiegender Anteil des Haftvermittlers und in einem dem Werkstück (5) abgewandten Teil der Gradientenschicht zumindest überwiegend ein Anteil des Barrierematerials enthalten ist. Ein Übergang der jeweiligen Bestandteile erfolgt zumindest in einem Teil der Gradientenschicht kontinuierlich entsprechend einem vorgebbaren Gradientenverlauf. In ähnlicher Weise ist es möglich, sowohl die Schicht zur Haftvermittlung als auch die Barriereschicht selbst als Gradientenschichten zu erzeugen.

Der Innenraum der Plasmakammer (17) und der Innenraum des Werkstückes (5) werden zunächst gemeinsam auf ein Druckniveau von etwa 20 mbar bis 50 mbar evakuiert. Anschließend wird der Druck im Innenraum des Werkstückes (5) weiter auf etwa 0,1 mbar abgesenkt. Während der Durchführung des Behandlungsvorganges wird ein Unterdruck von etwa 0,3 mbar aufrechterhalten.

Nach einem Abschluß des Beschichtungsvorganges wird die Lanze (36) wieder aus dem Innenraum des Werkstückes (5) entfernt und die Plasmakammer (17) sowie der Innenraum des Werkstückes (5) werden belüftet. Nach Erreichen des Umgebungsdruckes innerhalb der Kavität (4) wird die Kammerwandung (18) wieder angehoben, um eine Entnahme des beschichteten Werkstückes (5) sowie eine Eingabe eines neuen zu beschichtenden Werkstückes (5) durchzuführen. Zur Ermöglichung einer seitlichen Positionierung des Werkstückes (5) wird das Dichtelement (28) mindestens bereichsweise wieder in den Kammersockel (30) hinein verfahren.

Alternativ zur erläuterten Innenbeschichtung von Werkstükken (5) können auch Außenbeschichtungen, Sterilisationen oder Oberflächenaktivierungen durchgeführt werden.

Eine Positionierung der Kammerwandung (18), des Dichtelementes (28) und / oder der Lanze (36) kann unter Verwendung unterschiedlicher Antriebsaggregate erfolgen. Grundsätzlich ist die verwendung pneumatischer Antriebe und / oder elektrischer Antriebe, insbesondere in einer Ausführungsform als Linearmotor, denkbar.

## Patentansprüche

1. Verfahren zur Handhabung von Werkstücken (5) bei dem die Werkstücke von einem rotierenden Kopplungsrad (81) transportiert werden und bei dem mindestens zwei Werkstücke von einem gemeinsamen Halteelement (86) positioniert werden, wobei die Positionierung sowohl eine Drehbewegung relativ zu einer Rotationsachse des Kopplungsrades als auch eine Drehbewegung relativ zu einer quer zur Rotationsachse des Kopplungsrades verlaufenden Drehachse umfaßt, **dadurch gekennzeichnet, daß** eine Übergabe von Werkstücken (5) von dem Halteelement (86) auf mindestens eine Bezugsstation für die mindestens zwei vom Halteelement (86) positionierte Werkstücke (5) relativ zueinander zu unterschiedlichen Zeitpunkten durchgeführt wird.

2. Verfahren nach Anspruch 1, **dadurch gekennzeichnet, daß** der Übergabevorgang kurvengesteuert durchgeführt wird.

3. Verfahren nach Anspruch 1 oder 2,**dadurch gekennzeichnet, daß** die Werkstücke (5) im Bereich des Halteelementes (86) von zangenartigen Fixierelementen (97) positioniert werden.

4. Verfahren nach Anspruch 3, **dadurch gekennzeichnet, daß** die Fixierelemente (97) kurvengesteuert betätigt werden.

5. Verfahren nach einem der Ansprüche 1 bis 4, **dadurch gekennzeichnet, daß** das Kopplungsrad (81) um eine im Wesentlichen senkrecht verlaufende Rotationsachse bewegt wird.

6. Verfahren nach einem der Ansprüche 1 bis 5, **dadurch gekennzeichnet, daß** das Halteelement (86) um eine im Wesentlichen horizontal verlaufende Drehachse verschwenkt wird.

7. Verfahren nach einem der Ansprüche 1 bis 6, **dadurch gekennzeichnet, daß** das Halteelement (86) zyklisch jeweils um 180° hin- und herverschwenkt wird.

8. Verfahren nach einem der Ansprüche 1 bis 7, **dadurch gekennzeichnet, daß** die Schwenkbewegung des Halteelementes (86) von einer außenseitig an einem Sockel (84) des Kopplungsrades (81) positionierten Mantelkurve gesteuert wird.

9. Verfahren nach einem der Ansprüche 1 bis 8, **dadurch gekennzeichnet, daß** Zangenarme (98, 99) der Fixierelemente (97) relativ zueinander federnd verspannt werden.

10. Verfahren nach Anspruch 9, **dadurch gekennzeichnet, daß** die Zangenarme (98, 99) federnd in eine zur Fixierung des Werkstückes (5) vorgesehene Klemmpositionierung verspannt werden.

11. Verfahren nach einem der Ansprüche 1 bis 10, **dadurch gekennzeichnet, daß** das Kopplungsrad (81) zur Durchführung von Übergabevorgängen in einer Umgebung mindestens einer Plasmastation (3) verwendet wird.

12. Verfahren nach Anspruch 11, **dadurch gekennzeichnet, daß** die Plasmastation (3) von einem rotierenden Plasmarad (2) positioniert wird.

13. Verfahren nach einem der Ansprüche 1 bis 10, **dadurch gekennzeichnet, daß** das Kopplungsrad (81) zur Durchführung von Übergabevorgängen in einer Umgebung mindestens einer Blasstation (43) verwendet wird.

14. Verfahren nach Anspruch 11, **dadurch gekennzeichnet, daß** die Plasmastation (3) von einem rotierenden Blasrad (65) positioniert wird.

15. Verfahren nach einem der Ansprüche 1 bis 14, **dadurch gekennzeichnet, daß** vom Kopplungsrad (81) flaschenartige Werkstücke (5) positioniert werden.

16. Verfahren nach einem der Ansprüche 1 bis 15, **dadurch gekennzeichnet, daß** das Kopplungsrad (81) zur Durchführung von Übergabevorgängen in einer Umgebung einer Behandlungsstation für die Werkstücke (5) verwendet wird, wobei in der Behandlungsstation mindestens zwei Werkstücke (5) gleichzeitig behandelt werden.

17. Verfahren nach einem der Ansprüche 1 bis 16, **dadurch gekennzeichnet, daß** das Halteelement (86) mit einer Anzahl von Fixierelementen (97) versehen wird, die der Anzahl der gleichzeitig im Bereich der Behandlungsstation zu behandelnden Werkstücke (5) entspricht.

18. Vorrichtung zur Handhabung von Werkstücken, die als ein rotierendes Kopplungsrad (81) ausgebildet ist, das mindestens ein Halteelement (86) zur gemeinsamen Positionierung von mindestens zwei Werkstücken aufweist und bei der das Halteelement relativ zum Kopplungsrad drehbeweglich gelagert ist, **dadurch gekennzeichnet, daß** das Halteelement (86) mindestens zwei Fixierelemente (97) für die Werkstücke (5) aufweist, die jedes mit Ansteuerungselementen (103, 104) versehen sind, die die Fixierelemente (97) relativ zueinander zeitlich versetzt ansteuert.

19. Vorrichtung nach Anspruch 18, **dadurch gekennzeichnet, daß** das Kopplungsrad (81) zur Vorgabe einer Drehbewegung des Halteelementes (86) relativ zu einem Sockel (84) des Kopplungsrades (81) mit einer Kurvensteuerung versehen ist.

20. Vorrichtung nach Anspruch 18 oder 19, **dadurch gekennzeichnet, daß** die Fixierelemente (97) zangenartig ausgebildet sind.

21. Vorrichtung nach Anspruch 20, **dadurch gekennzeichnet, daß** das Kopplungsrad (81) zur Positionierung von Zangenarmen (98, 99) des Fixierelementes (97) mit einer Kurvensteuerung versehen ist.

22. Vorrichtung nach einem der Ansprüche 18 bis 21, **dadurch gekennzeichnet, daß** eine Mittellinie (82) des Kopplungsrades (81) als Rotationsachse im Wesentlichen senkrecht angeordnet ist.

23. Vorrichtung nach einem der Ansprüche 18 bis 22, **dadurch gekennzeichnet, daß** eine Drehachse (88) des Halteelementes (86) im Wesentlichen horizontal angeordnet ist.

24. Vorrichtung nach einem der Ansprüche 18 bis 23, **dadurch gekennzeichnet, daß** von der Kurvensteuerung für das Halteelement (86) ein Drehwinkelbereich von +/- 180° vorgegeben ist.

25. Vorrichtung nach einem der Ansprüche 18 bis 24, **dadurch gekennzeichnet, daß** die Kurvensteuerung für die Positionierung der Halteelemente (86) eine als Kurvenbahn (92) ausgebildete Mantelkurve umfaßt.

26. Vorrichtung nach einem der Ansprüche 18 bis 25, **dadurch gekennzeichnet, daß** die Zangenarme (98, 99) des Fixierelementes (97) von mindestens einer Feder (107) relativ zueinander verspannt sind.

27. Vorrichtung nach einem der Ansprüche 18 bis 26, **dadurch gekennzeichnet, daß** von der Feder (107) eine Positionierung der Zangenarme (98, 99) in einer Klemmpositionierung vorgeben ist.

28. Vorrichtung nach einem der Ansprüche 18 bis 27, **dadurch gekennzeichnet, daß** das Kopplungsrad (81) benachbart zu mindestens einer Plasmastation (3) zur Behandlung mindestens eines Werkstückes (5) angeordnet ist.

29. Vorrichtung nach Anspruch 28, **dadurch gekennzeichnet, daß** die Plasmastation (3) auf einem rotierenden Plasmarad (2) angeordnet ist.

30. Vorrichtung nach einem der Ansprüche 18 bis 27, **dadurch gekennzeichnet, daß** das Kopplungsrad (81) benachbart zu mindestens einer Blasstation (43) zur Behandlung mindestens eines Werkstückes (5) angeordnet ist.

31. Vorrichtung nach Anspruch 28, **dadurch gekennzeichnet, daß** die Plasmastation (3) auf einem rotierenden Blasrad (65) angeordnet ist.

32. Vorrichtung nach einem der Ansprüche 18 bis 31, **dadurch gekennzeichnet, daß** das Kopplungsrad (81) zur Handhabung von flaschenartigen Werkstücken (5) ausgebildet ist.

33. Vorrichtung nach einem der Ansprüche 18 bis 32, **dadurch gekennzeichnet, daß** das Kopplungsrad (81) benachbart zu einer Behandlungsstation zur gemeinsamen Behandlung von mindestens zwei Werkstücken (5) angeordnet ist.

34. Vorrichtung nach einem der Ansprüche 18 bis 33, **dadurch gekennzeichnet, daß** das Halteelement (86) mit einer Anzahl von Fixierelementen (97) ausgestattet ist, die gleich der Anzahl der von der Bearbeitungsstation aufgenommenen Werkstücke (5) gewählt ist.

## Claims

1. Method of handling workpieces (5), whereby the workpieces are transported by a rotating coupling wheel (81) and at least two workpieces are positioned by a common retaining element (86), which positioning involves both a rotating movement relative to a rotation axis of the coupling wheel and a rotating movement relative to a rotation axis extending transversely to the rotation axis of the coupling wheel, **characterised in that** workpieces (5) are transferred by the retaining element (86) at different times to at least one reference station for the at least two workpieces (5) positioned relative to one another by the retaining element (86).

2. Method as claimed in claim 1, **characterised in that** the transfer process is cam-controlled.

3. Method as claimed in claim 1 or 2, **characterised in that** the workpieces (5) are positioned in the region of the retaining element (86) by means of jaw-type fixing elements (97).

4. Method as claimed in claim 3, **characterised in that** the fixing elements (97) are operated under the control of a cam.

5. Method as claimed in one of claims 1 to 4, **characterised in that** the coupling wheel (81) is displaced about an essentially vertically extending rotation axis.

6. Method as claimed in one of claims 1 to 5, **characterised in that** the retaining element (86) is pivoted about an essentially horizontally extending pivot axis.

7. Method as claimed in one of claims 1 to 6, **characterised in that** the retaining element (86) is cyclically pivoted backwards and forwards by 180° respectively.

8. Method as claimed in one of claims 1 to 7, **characterised in that** the pivoting movement of the retaining element (86) is controlled by means of a cylinder cam positioned at the exterior on a base (84) of the coupling wheel (81).

9. Method as claimed in one of claims 1 to 8, **characterised in that** jaw arms (98, 99) of the fixing elements (97) are spring-biased relative to one another.

10. Method as claimed in claim 9, **characterised in that** the jaw arms (98, 99) are spring-biased in a clamping position provided as a means of fixing the workpiece (5).

11. Method as claimed in one of claims 1 to 10, **characterised in that** the coupling wheel (81) is used as a means of performing transfer manoeuvres in the vicinity of at least one plasma station (3).

12. Method as claimed in claim 11, **characterised in that** the plasma station (3) is positioned by means of a rotating plasma wheel (2).

13. Method as claimed in one of claims 1 to 10, **characterised in that** the coupling wheel (81) is used to perform transfer manoeuvres in the vicinity of at least one blowing station (43).

14. Method as claimed in claim 11, **characterised in that** the plasma station (3) is positioned by means of a rotating blowing wheel (65).

15. Method as claimed in one of claims 1 to 14, **characterised in that** bottle-type workpieces (5) are positioned by the coupling wheel (81).

16. Method as claimed in one of claims 1 to 15, **characterised in that** the coupling wheel (81) is used to perform transfer manoeuvres in the vicinity of a treatment station for the workpieces (5), at least two workpieces (5) being treated in the treatment station simultaneously.

17. Method as claimed in one of claims 1 to 16, **characterised in that** the retaining element (86) is provided with a number of fixing elements (97) corresponding in number to the number of workpieces (5) to be handled simultaneously in the region of the treatment station.

18. Device for handling workpieces, provided in the form of a rotating coupling wheel (81), which has at least one retaining element (86) for jointly positioning at least two workpieces and on which the retaining element is mounted so as to be displaceable in rotation relative to the coupling wheel, **characterised in that** the retaining element (86) has at least two fixing elements (97) for the workpieces (5), each of which is provided with control elements (103, 104) which control the fixing elements (97) relative to one another with a time delay.

19. Device as claimed in claim 18, **characterised in that** the coupling wheel (81) is provided with a cam control for pre-setting a rotating movement of the retaining element (86) relative to a base (84) of the coupling wheel (81).

20. Device as claimed in claim 18 or 19, **characterised in that** the fixing elements (97) are of a jaw-type design.

21. Device as claimed in claim 20, **characterised in that** the coupling wheel (81) is provided with a cam control for positioning jaw-type jaw arms (98, 99) of the fixing element (97).

22. Device as claimed in one of claims 18 to 21, **characterised in that** a centre line (82) of the coupling wheel (81) constituting the rotation axis is disposed essentially vertically.

23. Device as claimed in one of claims 18 to 22, **characterised in that** a rotation axis (88) of the retaining element (86) is disposed essentially horizontally.

24. Device as claimed in one of claims 18 to 23, **characterised in that** a rotation angle range of +/- 180° is pre-set for the retaining element (86) by means of the cam control.

25. Device as claimed in one of claims 18 to 24, **characterised in that** the cam control has a cylinder cam constituting a cam track (92) for positioning the retaining elements (86).

26. Device as claimed in one of claims 18 to 25, **characterised in that** the jaw arms (98, 99) of the fixing element (97) are biased relative to one another by means of at least one spring (107).

27. Device as claimed in one of claims 18 to 26, **characterised in that** the jaw arms (98, 99) are positioned in a pre-set clamping position by means of the spring (107).

28. Device as claimed in one of claims 18 to 27, **characterised in that** the coupling wheel (81) is disposed adjacent to at least one plasma station (3) for treating at least one workpiece (5).

29. Device as claimed in claim 28, **characterised in that** the plasma station (3) is disposed on a rotating plasma wheel (2).

30. Device as claimed in one of claims 18 to 27, **characterised in that** the coupling wheel (81) is disposed adjacent to at least one blowing station (43) for treating at least one workpiece (5).

31. Device as claimed in claim 28, **characterised in that** the plasma station (3) is disposed on a rotating blowing wheel (65).

32. Device as claimed in one of claims 18 to 31, **characterised in that** the coupling wheel (81) is designed for handling bottle-type workpieces (5).

33. Device as claimed in one of claims 18 to 32, **characterised in that** the coupling wheel (81) is disposed adjacent to a treatment station for jointly treating at least two workpieces (5).

34. Device as claimed in one of claims 18 to 33, **characterised in that** the retaining element (86) is equipped with a number of fixing elements (97) which is selected so as to be the same as the number of workpieces (5) accommodated by the processing station.

## Revendications

1. Procédé pour la manipulation de pièces (5), dans lequel les pièces sont transportées par une roue de couplage rotative (81) et dans lequel au moins deux pièces sont positionnées par un élément support commun (86), où le positionnement comprend non seulement un mouvement de rotation par rapport à un axe de rotation de la roue de couplage, mais également un mouvement de rotation par rapport à un axe de rotation transversal à l'axe de rotation de la roue de couplage, **caractérisé en ce qu'**un transfert des pièces (5) depuis l'élément support (86) à au moins un poste de référence pour les au moins deux pièces (5) positionnées sur l'élément support (86) est réalisé à des moments différents l'un par rapport à l'autre.

2. Procédé selon la revendication .., **caractérisé en ce que** le processus de transfert est réalisé de manière commandée par came.

3. Procédé selon la revendication 1 ou 2, **caractérisé en ce que** les pièces sont positionnées au niveau de l'élément support (86) par des éléments de fixation (97) de type pince.

4. Procédé selon la revendication 3, **caractérisé en ce que** les éléments de fixation (97) sont actionnés de manière commandée par came.

5. Procédé selon l'une des revendications 1 à 4. **caractérisé en ce que** la roue de couplage (81) est déplacée autour d'un axe de rotation essentiellement vertical.

6. Procédé selon l'une des revendications 1 à 5, **caractérisé en ce que** l'élément support (86) oscille autour d'un axe de rotation essentiellement horizontal.

7. Procédé selon l'une des revendications 1 à 6, **caractérisé en ce que** l'élément support (86) oscille d'avant en arrière, de manière cyclique, chaque fois de 180°.

8. Procédé selon l'une des revendications 1 à 7, **caractérisé en ce que** le mouvement d'oscillation de l'élément support (86) est réglé par une came périphérique positionné de manière extérieure, sur un socle (84) de la roue de couplage (81).

9. Procédé selon l'une des revendications 1 à 8, **caractérisé en ce que** les bras de pince (98, 99) de l'élément de fixation (97) sont étendus à la manière d'un ressort, l'un par rapport à l'autre.

10. Procédé selon la revendication 9, **caractérisé en ce que** les bras de pince (98, 99) sont tendus à la manière d'un ressort, en une position de pince prévue pour la fixation de la pièce (5).

11. Procédé selon l'une des revendications 1 à 10, **caractérisé en ce que** la roue de couplage (81) est utilisée pour réaliser le processus de transfert au voisinage d'au moins un poste à plasma (3).

12. Procédé selon la revendication 11, **caractérisé en ce que** le poste à plasma (3) est positionné sur une roue à plasma (2) rotative.

13. Procédé selon l'une des revendications 1 à 10, **caractérisé en ce que** la roue de couplage (81) est utilisée pour réaliser le processus de transfert au voisinage d'au moins un poste de soufflage (43).

14. Procédé selon la revendication 11, **caractérisé en ce que** le poste à plasma (3) est positionné sur une roue de soufflage (65) rotative.

15. Procédé selon l'une des revendications 1 à 14, **caractérisé en ce que** des pièces (5) de type bouteille sont positionnées sur la roue de couplage (81).

16. Procédé selon l'une des revendications 1 à 15, **caractérisé en ce que** la roue de couplage (81) est utilisée pour réaliser le processus de transfert au voisinage d'un poste de traitement pour les pièces (5), où dans le poste de traitement, au moins deux pièces (5) sont traitées simultanément.

17. Procédé selon l'une des revendications 1 à 16, **caractérisé en ce que** l'élément support (86) est muni d'un certain nombre d'élément de fixation (97), qui correspond au nombre de pièces (5) à traiter simultanément au niveau du poste de traitement.

18. Dispositif pour la manipulation de pièces (5), qui est formé comme une roue de couplage (81) rotative, qui présente au moins un élément de fixation (86) pour le positionnement commun d'au moins deux pièces et où l'élément support est positionné de manière à pouvoir être déplacé par rotation relativement à la roue de couplage, **caractérisé en ce que** l'élément support (86) présente au moins deux éléments de fixation (97) pour les pièces (5), qui sont munis chaque fois, d'éléments de réglage (103, 104), qui règlent les éléments de fixation (97) temporellement, l'un par rapport à l'autre.

19. Dispositif selon la revendication 18, **caractérisé en ce que** la roue de couplage (81) est munie d'un réglage à came pour réaliser un mouvement rotatif de l'élément support (86) par rapport à un socle (84) de la roue de couplage (81).

20. Dispositif selon la revendication 18 ou 19, **caractérisé en ce que** les éléments de fixation (97) sont de type pince.

21. Dispositif selon la revendication 20, **caractérisé en ce que** la roue de couplage (81) est munie d'un réglage à came pour le positionnement des bras de pince (98, 99) de l'élément de fixation (97).

22. Dispositif selon l'une quelconque des revendications 18 à 21, **caractérisé en ce qu'**une ligne médiane (82) de la roue de couplage (81) est disposée essentiellement verticalement comme axe de rotation .

23. Dispositif selon l'une quelconque des revendications 18 à 22, **caractérisé en ce qu'**un axe de rotation (88) de l'élément support (86) est disposé essentiellement horizontalement.

24. Dispositif selon l'une quelconque des revendications 18 à 23, **caractérisé en ce qu'**une gamme d'angle de rotation de +/- 180° est prévue pour le réglage par came, pour l'élément support (86).

25. Dispositif selon l'une quelconque des revendications 18 à 24, **caractérisé en ce que** le réglage par came pour le positionnement de l'élément support (86) comprend une came périphérique formée comme un chemin incurvé (92).

26. Dispositif selon l'une quelconque des revendications 18 à 25, **caractérisé en ce que** les bras de pince (98, 99) de l'élément de fixation (97) sont tendus l'un par rapport à l'autre par au moins un ressort (107).

27. Dispositif selon l'une quelconque des revendications 18 à 26, **caractérisé en ce que** par le ressort (107), un positionnement des bras de pince (98, 99) est donné dans un positionnement de pince.

28. Dispositif selon l'une quelconque des revendications 18 à 27, **caractérisé en ce que** la roue de couplage (81) est disposée à proximité d'au moins un poste à plasma (3) pour le traitement; d'au moins une pièce (5).

29. Dispositif selon la revendication 28, **caractérisé en ce que** le poste à plasma (3) est disposé sur une roue à plasma (2) rotative.

30. Dispositif selon l'une quelconque des revendications 18 à 27, **caractérisé en ce que** la roue de couplage (81) est disposée à proximité d'au moins un poste de soufflage (43) pour le traitement d'au moins une pièce (5).

31. Dispositif selon la revendication 28, **caractérisé en ce que** le poste à plasma (3) est disposé sur une roue de soufflage (65) rotative.

32. Dispositif selon l'une quelconque des revendications 18 à 31, **caractérisé en ce que** la roue de couplage (81) est formée pour la manipulation de pièces (5) de type bouteille.

33. Dispositif selon l'une quelconque des revendications 18 à 32, **caractérisé en ce que** la roue de couplage (81) est disposée à proximité d'un poste de traitement pour le traitement commun d'au moins deux pièces (5) .

34. Dispositif selon l'une quelconque des revendications 18 à 33, **caractérisé en ce que** l'élément support (86) est équipé d'un certain nombre d'éléments de fixation (97), qui est choisi égal au nombre de pièces (5) prises du poste de travail.
